# EUROPEAN PATENT SPECIFICATION

(11) **EP 1 873 827 B1**
(45) Date of publication and mention of the grant of the patent: **09.09.2020**
(21) Application number: 06731255.3
(22) Date of filing: 06.04.2006
(51) Int. Cl.: H01L 23/473, H01L 23/36, H01L 23/367, H05K 3/00, H05K 3/34, H01L 23/373, H05K 1/03, H05K 3/40

(54) **HEAT RADIATING DEVICE**
WÄRMEABLEITER
DISSIPATEUR DE CHALEUR

(30) Priority: 06.04.2005 JP 2005110175
(43) Date of publication of application: 02.01.2008
(60) Divisional application: 15150109.5
(73) Proprietor: SHOWA DENKO K.K., Tokyo 105-8518 (JP)
(72) Inventor: OTOSHI, Kota c/o KABUSHIKI KAISHA TOYOTA JIDOSHOKK, Kariya-shi, Aichi448-8671 (JP); KONO, Eiji c/o KABUSHIKI KAISHA TOYOTA JIDOSHOKKI, Kariya-shi, Aichi448-8671 (JP); KUBO, Hidehito, Toyoda-cho-Kariya-shi, Aichi-448-8671 (JP); KIMBARA, Masahiko c/o KABUSHIKI KAISHA TOYOTA, Kariya-shi, Aichi 448-8671 (JP); FURUKAWA, Yuichi c/o SHOWA DENKO K.K.,, Oyama-shi, Tochigi; 3238678 (JP); YAMAUCHI, Shinobu c/o SHOWA DENKO K.K.,, Oyama-shi, Tochigi; 3238678 (JP); HOSHINO, Ryoichi c/o SHOWA DENKO K.K.,, Oyama-shi, Tochigi; 3238678 (JP); WAKABAYASHI, Nobuhiro c/o SHOWA DENKO K.K.,, Oyama-shi, Tochigi; 3238678 (JP); NAKAGAWA, Shintaro c/o SHOWA DENKO K.K.,, Oyama-shi, Tochigi; 3238678 (JP)
(74) Representative: Cabinet Beau de Loménie
(86) International application number: PCT/JP2006/307307
(87) International publication number: WO 2006/109660

(56) References cited:
- EP-A1- 1 450 401
- EP-A2- 1 089 334
- DE-A1- 10 337 640
- JP-A- 08 078 586
- JP-A- 08 083 872
- JP-A- H10 189 845
- JP-A- 2003 017 627

## Description

### TECHNICAL FIELD

The present invention relates to a heat radiator, and more particularly to a heat radiator which includes an insulating substrate whose first side serves as a heat-generating-element-mounting side, and a heat sink fixed to a second side of the insulating substrate and which radiates, from the heat sink, heat generated from a heat-generating-element, such as a semiconductor device, mounted on the insulating substrate.

The term "aluminum" as used herein and in the appended claims encompasses aluminum alloys in addition to pure aluminum, except for the case where "pure aluminum" is specified.

### BACKGROUND ART

In a power module which uses a semiconductor device, such as an IGBT (Insulated Gate Bipolar Transistor), the semiconductor device must be held at a predetermined temperature or lower by means of efficiently radiating heat generated therefrom. Conventionally, in order to meet the requirement, a heat radiator is used. The heat radiator includes an insulating substrate which is formed of a ceramic, such as Al₂O₃ or AlN, and whose first side serves as a heat-generating-element-mounting side, and a heat sink which is formed of a high-thermal-conduction metal, such as aluminum or copper (including copper alloys; hereinafter, the same is applied), and is soldered to a second side of the insulating substrate. A semiconductor device is soldered to the heat-generating-element-mounting side of the insulating substrate of the heat radiator, thereby forming the power module.

A power module used in, for example, a hybrid car must maintain the heat radiation performance of a heat radiator over a long term. The above-mentioned conventional heat radiator involves the following problem. Under some working conditions, thermal stress arises from a difference in thermal expansion coefficient between the insulating substrate and the heat sink and causes cracking in the insulating substrate, cracking in a solder layer which bonds the insulating substrate and the heat sink together, or warpage of a bond surface of the heat sink bonded to the insulating substrate. Such cracking or warpage impairs heat radiation performance.

A proposed heat radiator in which the above problem is solved includes an insulating substrate whose first side serves as a heat-generating-element-mounting side, a heat radiation member which is soldered to a second side of the insulating substrate, and a heat sink which is screwed on the heat radiation member. The heat radiation member includes a pair of platelike heat-radiation-member bodies formed of a high-thermal-conduction material, such as aluminum or copper, and a low-thermal-expansion material, such as an Invar alloy, intervening between the platelike heat-radiation-member bodies. Such a system is described in Japanese Patent Application Laid-Open (*koka*i) No. 2004-153075.

However, the heat radiator described in Japanese Patent Application Laid-Open (k*oka*i) No. 2004-153075, which is called in the following Patent Document 1, must use the heat radiation member formed of a high-thermal-conduction material and a low-thermal-expansion material; thus, material cost is increased. Furthermore, since the heat radiation member and the heat sink are merely screwed together, thermal conduction therebetween is insufficient, resulting in a failure to provide sufficient heat radiation performance.

EP 1 450 401 discloses a heat radiator according to the preamble of claim 1. EP 1 089 334 relates to a ceramic circuit board. JP H10 189845 relates to a heat sink for semiconductor device.

### DISCLOSURE OF THE INVENTION

### PROBLEMS TO BE SOLVED BY THE INVENTION

An object of the present invention is to solve the above problem and to provide a heat radiator whose material cost is low and which exhibits excellent heat radiation performance.

### MEANS FOR SOLVING THE PROBLEMS

To achieve the above object, a heat radiator according to the present invention is defined by claim 1. Preferred embodiments of the invention are defined in the dependent claims.

In a heat radiator as defined by claim 1, the aluminum plate used to form the stress relaxation member has a thickness of 0.3 mm to 3 mm, for the following reason. If the aluminum plate is too thin, deformation of the stress relaxation member may become insufficient when thermal stress arises in the heat radiator from a difference in thermal expansion coefficient between the insulating substrate and the heat sink, with the potential result that the stress relaxation member fails to exhibit sufficient stress-relaxing performance. If the aluminum plate is too thick, thermal conductivity may drop. Furthermore, even when thermal stress arises in the heat radiator from a difference in thermal expansion coefficient between the insulating substrate and the heat sink, the stress relaxation member is deformed by the effect of the stress-absorbing space; thus, the thermal stress is relaxed, thereby preventing cracking in the insulating substrate, cracking in a bond zone between the insulating substrate and the stress relaxation member, or warpage of a bond surface of the heat sink bonded to the insulating substrate. Accordingly, heat radiation performance is maintained over a long term. Also, use of such a stress relaxation member lowers cost of the stress relaxation member, thereby lowering material cost for the heat radiator.

The stress relaxation member is brazed to the insulating substrate and to the heat sink. Thus, bonding of the stress relaxation member and the insulating substrate and bonding of the stress relaxation member and the heat sink can be performed simultaneously, thereby improving workability in fabrication of the heat radiator. According to the heat radiator described in Patent Document 1, after the insulating substrate and the heat radiation member are soldered together, the heat radiation member and the heat sink must be screwed together; therefore, workability in fabrication of the heat radiator is poor.

In the heat radiator according to claim 1, through holes in a staggered arrangement form the stress-absorbing space.

The through holes may be formed in at least a portion of the aluminum plate which corresponds to a perimetric portion of the insulating substrate.

Such a heat radiator exhibits excellent thermal-stress relaxation effect. A largest thermal stress or strain is likely to arise in a perimetric portion of the insulating substrate of the heat radiator. However, by virtue of the above configuration, a portion of the aluminum plate corresponding to the perimetric portion of the insulating substrate is apt to be deformed by the effect of the through holes, thereby relaxing the thermal stress.

The through holes may be of a non-angular shape and have a circle-equivalent diameter of 1 mm to 4 mm.

The term "non-angular" as used herein and in the appended claims refers to a shape which does not have a mathematically defined acute angle, obtuse angle, or right angle; for example, a circle, an ellipse, an elongated circle, or a substantially polygonal shape whose corners are rounded. The term "circle-equivalent diameter" as used herein and in the appended claims refers to the diameter of a circle whose area is equal to that of a shape in question.

The through holes have a circle-equivalent diameter of 1 mm to 4 mm, for the following reason. If the circle-equivalent diameter of the through holes is too small, deformation of the stress relaxation member may become insufficient when thermal stress arises in the heat radiator from a difference in thermal expansion coefficient between the insulating substrate and the heat sink, with the potential result that the stress relaxation member fails to exhibit sufficient stress-relaxing performance. If the circle-equivalent diameter of the through holes is too large, thermal conductivity may drop. Particularly, in the case where the stress relaxation member is brazed to the insulating substrate and to the heat sink, if the circle-equivalent diameter is too small, the through holes may be filled with a brazing material, with the potential result that the stress relaxation member is not deformed at all even when thermal stress arises in the heat radiator.

A percentage of a total area of all of the through holes to an area of one side of the aluminum plate may be 3% to 50%.

The percentage of the total area of all of the through holes to the area of one side of the aluminum plate is 3% to 50%, for the following reason. If the percentage is too low, deformation of the stress relaxation member may become insufficient when thermal stress arises in the heat radiator from a difference in thermal expansion coefficient between the insulating substrate and the heat sink, with the potential result that the stress relaxation member fails to exhibit sufficient stress-relaxing performance. If the percentage is too high, thermal conductivity may drop.

The aluminum plate may be formed of pure aluminum having a purity of 99% or higher.

Accordingly, wettability of a molten brazing material on the stress relaxation member becomes excellent when the stress relaxation member and the insulating substrate or the metal layer of the insulating substrate are to be brazed together and when the stress relaxation member and the heat sink are to be brazed together, thereby improving brazing workability. Furthermore, when brazing heat causes a drop in the strength of the stress relaxation member and generation of thermal stress in the heat radiator, the stress relaxation member is apt to be deformed, thereby yielding excellent stress relaxation effect.

The invention also relates to a power module comprising a heat radiator according to the present invention, and a semiconductor device mounted on the insulating substrate of the heat radiator.

### BRIEF DESCRIPTION OF THE DRAWINGS

[FIG. 1] Vertical sectional view of a portion of a power module which uses a heat radiator, showing a first embodiment of a heat radiator according to the present invention.
[FIG. 2] Perspective view showing a stress relaxation member used in the heat radiator of FIG. 1.
[FIG. 3] View equivalent to FIG. 1, showing a second embodiment of the heat radiator according to the present invention.
[FIG. 4] Perspective view showing a first modified embodiment of the stress relaxation member.
[FIG. 5] Partially cutaway perspective view showing a second modified embodiment (which does not form part of the claimed invention) of the stress relaxation member.
[FIG. 6] Partially cutaway perspective view showing a third modified embodiment of the stress relaxation member.
[FIG. 7] Partially cutaway perspective view showing a fourth modified embodiment (which does not form part of the claimed invention) of the stress relaxation member.
[FIG. 8] Partially cutaway perspective view showing a fifth modified embodiment (which does not form part of the claimed invention) of the stress relaxation member.
[FIG. 9] Partially cutaway perspective view showing a sixth modified embodiment (which does not form part of the claimed invention) of the stress relaxation member.
[FIG. 10] Partially cutaway perspective view showing a seventh modified embodiment (which does not form part of the claimed invention) of the stress relaxation member.
[FIG. 11] Partially cutaway perspective view showing an eighth modified embodiment (which does not form part of the claimed invention) of the stress relaxation member.
[FIG. 12] Partially cutaway perspective view showing a ninth modified embodiment (which does not form part of the claimed invention) of the stress relaxation member.
[FIG. 13] Perspective view showing a tenth modified embodiment (which does not form part of the claimed invention) of the stress relaxation member.
[FIG. 14] Perspective view showing an eleventh modified embodiment (which does not form part of the claimed invention) of the stress relaxation member.
[FIG. 15] Perspective view showing a twelfth modified embodiment (which does not form part of the claimed invention) of the stress relaxation member.
[FIG. 16] Perspective view showing a thirteenth modified embodiment (which does not form part of the claimed invention) of the stress relaxation member.
[FIG. 17] Perspective view showing a fourteenth modified embodiment (which does not form part of the claimed invention) of the stress relaxation member.
[FIG. 18] Perspective view showing a fifteenth modified embodiment (which does not form part of the claimed invention) of the stress relaxation member.
[FIG. 19] Perspective view showing a sixteenth modified embodiment (which does not form part of the claimed invention) of the stress relaxation member.
[FIG. 20] Perspective view showing a seventeenth modified embodiment (which does not form part of the claimed invention) of the stress relaxation member.
[FIG. 21] Perspective view showing an eighteenth modified embodiment (which does not form part of the claimed invention) of the stress relaxation member.

### BEST MODE FOR CARRYING OUT THE INVENTION

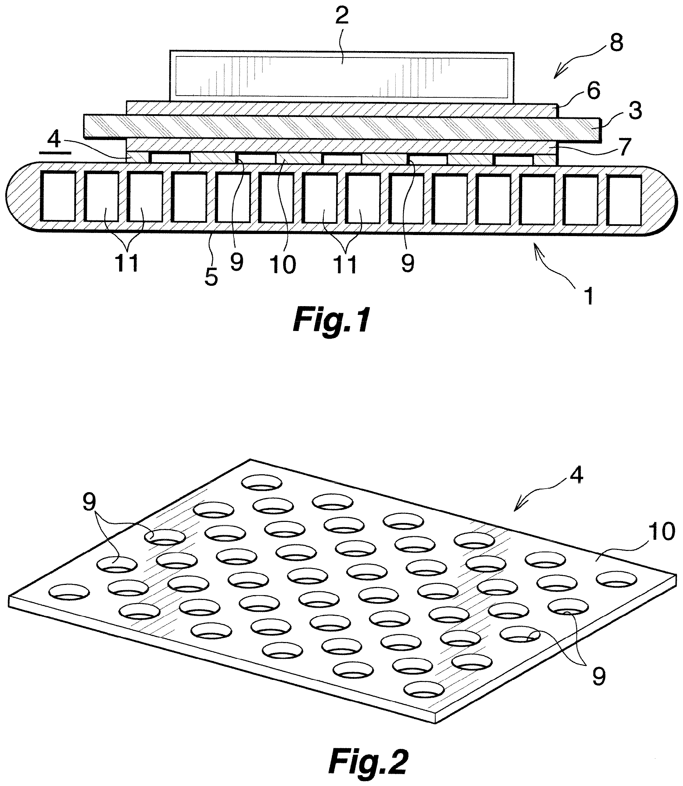

Embodiments of the present invention will next be described with reference to the drawings. The upper and lower sides of FIG. 1 will be referred to as "upper" and "lower," respectively. In all the drawings, like features or parts are denoted by like reference numerals, and repeated description thereof is omitted.

FIG. 1 shows a portion of a power module which uses a heat radiator of a first embodiment of the present invention. FIG. 2 shows a stress relaxation member.

In FIG. 1, the power module includes a heat radiator (1) and a semiconductor device (2); for example, an IGBT, mounted on the heat radiator (1).

The heat radiator (1) includes an insulating substrate (3) which is formed of a ceramic and whose upper side serves as a heat-generating-element-mounting side; a stress relaxation member (4) bonded to the lower side of the insulating substrate (3); and a heat sink (5) bonded to the lower side of the stress relaxation member (4).

The insulating substrate (3) may be formed of any ceramic so long as it satisfies requirements for insulating characteristics, thermal conductivity, and mechanical strength. For example, Al₂O₃ or AlN is used to form the insulating substrate (3). A circuit layer (6) is formed on the upper surface of the insulating substrate (3), and the semiconductor device (2) is soldered onto the circuit layer (6). The solder layer is not shown. The circuit layer (6) is formed of a metal having excellent electrical conductivity, such as aluminum or copper. Preferably, the circuit layer (6) is formed of a pure aluminum having high purity, which exhibits high electrical conductivity, high deformability, and excellent solderability in relation to a semiconductor device. A metal layer (7) is formed on the lower surface of the insulating substrate (3). The stress relaxation member (4) is brazed to the metal layer (7). The brazing-material layer is not shown. Preferably, the metal layer (7) is formed of a metal having excellent thermal conductivity, such as aluminum or copper. Preferably, the metal layer (7) is formed of a pure aluminum having high purity, which exhibits high thermal conductivity, high deformability, and excellent wettability in relation to a molten brazing material. The insulating substrate (3), the circuit layer (6), and the metal layer (7) constitute a power module substrate (8).

The stress relaxation member (4) is formed of a high-thermal-conduction material and has stress-absorbing spaces. As shown in FIG. 2, the stress relaxation member (4) is formed of an aluminum plate (10) in which a plurality of non-angular holes; herein, circular through holes (9), are formed in a staggered arrangement, and the through holes (9) serve as stress-absorbing spaces. The circular through holes (9) are formed in at least a portion of the aluminum plate (10) which corresponds to a perimetric portion of the insulating substrate (3); i.e., in the entire region of the aluminum plate (10), including a perimetric portion corresponding to the perimetric portion of the insulating substrate (3). Preferably, the aluminum plate (10) is formed of a pure aluminum having a purity of 99% or higher, desirably 99.5% or higher, which exhibits high thermal conductivity, high deformability induced by a drop in strength caused by brazing heat, and excellent wettability in relation to a molten brazing material. The thickness of the aluminum plate (10) is preferably 0.3 mm to 3 mm, more preferably 0.3 mm to 1.5 mm. The circle-equivalent diameter of the through holes (9) (here, the diameter of the through holes (9), because the through holes (9) are circular) is preferably 1 mm to 4 mm. Preferably, the percentage of the total area of all of the through holes (9) to the area of one side of the aluminum plate (10) is 3% to 50%.

Preferably, the heat sink (5) assumes a flat, hollow shape in which a plurality of cooling-fluid channels (11) are formed in parallel, and is formed of aluminum, which exhibits excellent thermal conductivity and is light. A cooling fluid may be either liquid or gas.

Brazing between the stress relaxation member (4) and the metal layer (7) of the power module substrate (8) and brazing between the stress relaxation member (4) and the heat sink (5) are performed, for example, as follows. The stress relaxation member (4) is formed of an aluminum brazing sheet which is composed of a core formed of pure aluminum, and aluminum brazing-material layers covering respective opposite sides of the core. Examples of an aluminum brazing-material include an Al-Si alloy and an Al-Si-Mg alloy. Preferably, the thickness of the aluminum brazing-material layer is about 10 µm to 200 µm. When the thickness is too small, lack of supply of the brazing material arises, potentially causing defective brazing. When the thickness is too large, excess supply of the brazing material arises, potentially causing generation of voids and a drop in thermal conductivity.

Next, the power module substrate (8), the stress relaxation member (4), and the heat sink (5) are arranged in layers and restrained together by use of an appropriate jig to thereby apply an appropriate load to bond surfaces. The resultant assembly is heated to 570°C to 600°C in a vacuum or an inert gas atmosphere. Thus, brazing of the stress relaxation member (4) and the metal layer (7) of the power module substrate (8) and brazing of the stress relaxation member (4) and the heat sink (5) are performed simultaneously.

Alternatively, brazing of the stress relaxation member (4) and the metal layer (7) of the power module substrate (8) and brazing of the stress relaxation member (4) and the heat sink (5) may performed as follows. The stress relaxation member (4) is formed of a bare material of the above-mentioned pure aluminum. The power module substrate (8), the stress relaxation member (4), and the heat sink (5) are arranged in layers. In this arrangement, a sheetlike aluminum brazing-material of, for example, an Al-Si alloy or an Al-Si-Mg alloy intervenes between the stress relaxation member (4) and the metal layer (7) of the power module substrate (8) and between the stress relaxation member (4) and the heat sink (5). Preferably, the thickness of the sheetlike aluminum brazing-material is about 10 µm to 200 µm. When the thickness is too small, lack of supply of the brazing material arises, potentially causing defective brazing. When the thickness is too large, excess supply of the brazing material arises, potentially causing generation of voids and a drop in thermal conductivity. Subsequently, brazing is performed as in the above-mentioned case of use of the aluminum brazing sheet. Thus, brazing of the stress relaxation member (4) and the metal layer (7) of the power module substrate (8) and brazing of the stress relaxation member (4) and the heat sink (5) are performed simultaneously.

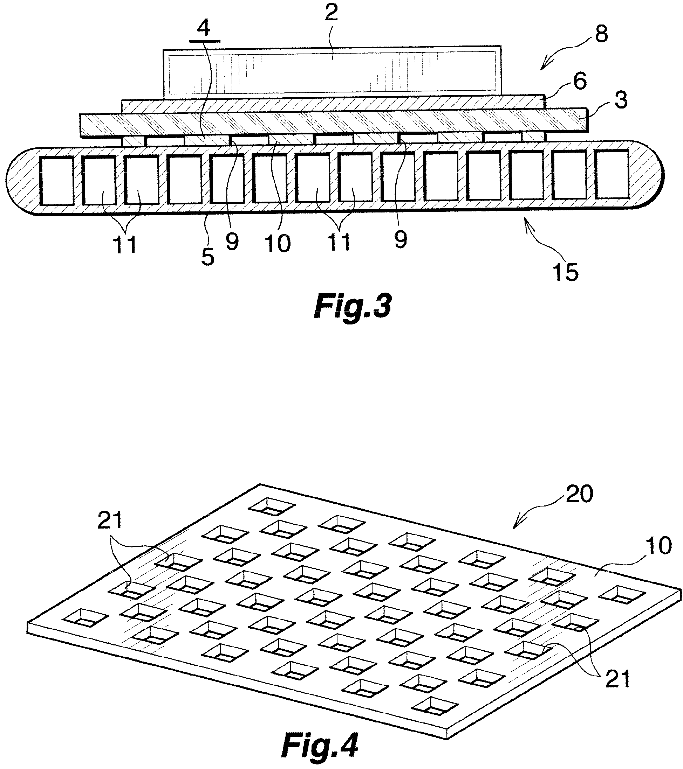

FIG. 3 shows a second embodiment of the heat radiator according to the present invention.

In the case of a heat radiator (15) shown in FIG. 3, the metal layer (7) is not formed on the lower surface of the insulating substrate (3) of the power module substrate (8); i.e., the stress relaxation member (4) is directly brazed to the insulating substrate (3). This brazing is performed in a manner similar to that of the first embodiment described above.

FIGS. 4 to 21 show modified embodiments of the stress relaxation member.

A stress relaxation member (20) shown in FIG. 4 is formed of the aluminum plate (10) in which a plurality of rectangular through holes (21) are formed in a staggered arrangement, and the through holes (21) serve as stress-absorbing spaces. The through holes (21) are formed in at least a portion of the aluminum plate (10) which corresponds to a perimetric portion of the insulating substrate (3); i.e., in the entire region of the aluminum plate (10), including a perimetric portion corresponding to the perimetric portion of the insulating substrate (3). Preferably, as in the case of the stress relaxation member (4) shown in FIG. 2, the percentage of the total area of all of the through holes (21) to the area of one side of the aluminum plate (10) is 3% to 50%.

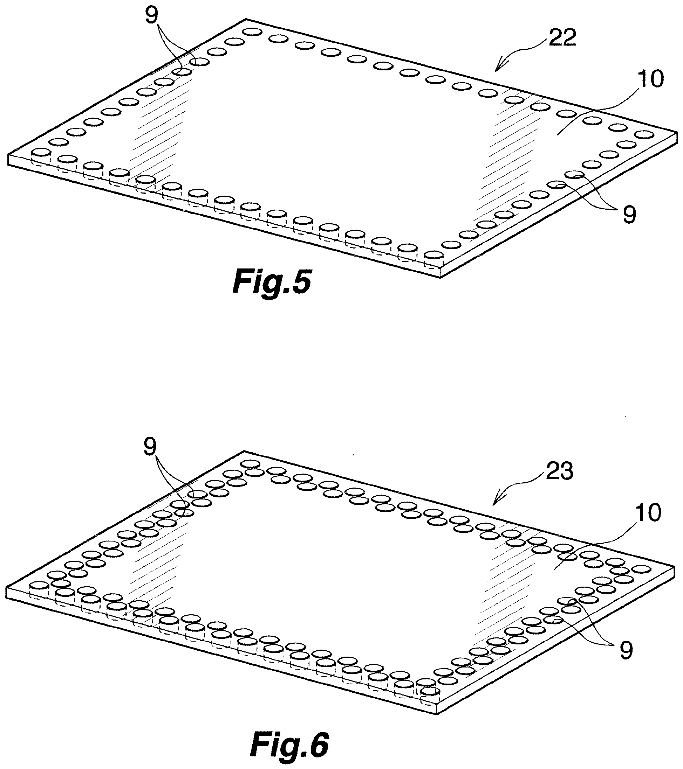

A stress relaxation member (22) shown in FIG. 5 (which does not form part of the claimed invention) is formed of the aluminum plate (10) in which a plurality of the circular through holes (9) are formed only in a perimetric portion; i.e., in a portion corresponding to a perimetric portion of the insulating substrate (3). Also, in this case, preferably, as in the case of the stress relaxation member (4) shown in FIG. 2, the percentage of the total area of all of the through holes (9) to the area of one side of the aluminum plate (10) is 3% to 50%.

A stress relaxation member (23) shown in FIG. 6 is formed of the aluminum plate (10) in which a plurality of the circular through holes (9) are formed in two inner and outer rows only in a perimetric portion; i.e., in a portion corresponding to a perimetric portion of the insulating substrate (3). Also, in this case, preferably, as in the case of the stress relaxation member (4) shown in FIG. 2, the percentage of the total area of all of the through holes (9) to the area of one side of the aluminum plate (10) is 3% to 50%.

In the stress relaxation members (22) and (23) shown in FIGS. 5 and 6, respectively, the rectangular through holes (21) may be formed in place of the circular through holes (9). In either case, the through holes (9) and (21) serve as stress-absorbing spaces.

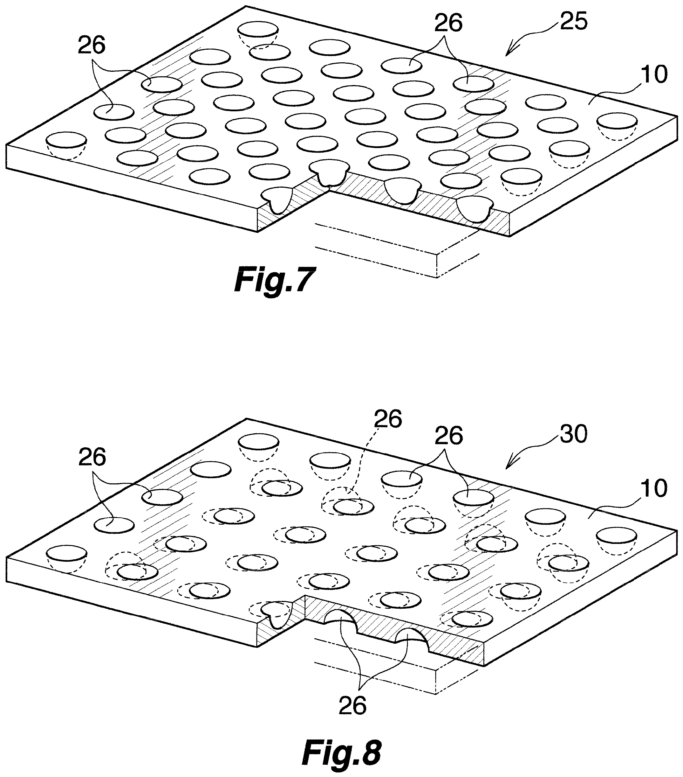

A stress relaxation member (25) shown in FIG. 7 (which does not form part of the claimed invention) is formed of the aluminum plate (10) in which a plurality of spherical recesses (26) are formed in a staggered arrangement on one side, and the recesses (26) serve as stress-absorbing spaces.

A stress relaxation member (30) shown in FIG. 8 (which does not form part of the claimed invention) is formed of the aluminum plate (10) in which a plurality of the spherical recesses (26) are formed in vertical and horizontal rows on opposite sides, and the recesses (26) serve as stress-absorbing spaces. The recesses (26) formed on one side of the aluminum plate (10) differ from the recesses (26) formed on the other side in position as viewed in plane.

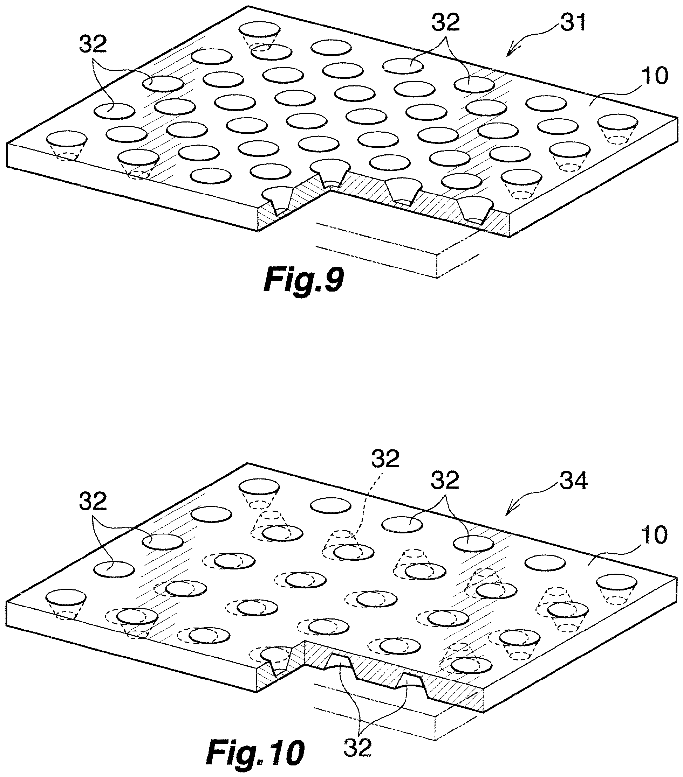

A stress relaxation member (31) shown in FIG. 9 (which does not form part of the claimed invention) is formed of the aluminum plate (10) in which a plurality of truncated-cone-shaped recesses (32) are formed in a staggered arrangement on one side, and the recesses (32) serve as stress-absorbing spaces.

A stress relaxation member (34) shown in FIG. 10 (which does not form part of the claimed invention) is formed of the aluminum plate (10) in which a plurality of the truncated-cone-shaped recesses (32) are formed in vertical and horizontal rows on opposite sides, and the recesses (32) serve as stress-absorbing spaces. The recesses (32) formed on one side of the aluminum plate (10) differ from the recesses (32) formed on the other side in position as viewed in plane.

In the stress relaxation members (25), (30), (31), and (34) shown in FIGS. 7 to 10, respectively, the recesses (26) and (32) are formed in the entire region of the aluminum plate (10), including at least a perimetric portion corresponding to a perimetric portion of the insulating substrate (3). However, as in the case of the stress relaxation members (22) and (23) shown in FIGS. 5 and 6, respectively, the recesses (26) and (32) may be formed only in the perimetric portion corresponding to the perimetric portion of the insulating substrate (3). In the stress relaxation members (25), (30), (31), and (34) shown in FIGS. 7 to 10, respectively, since the openings of the recesses (26) and (32) are circular, the recesses (26) and (32) preferably have a circle-equivalent diameter; i.e., a diameter, of 1 mm to 4 mm. Preferably, the percentage of the total area of openings of all of the recesses (26) or (32) to an area of the side of the aluminum plate (10) on which the recesses (26) or (32) are formed is 3% to 50%.

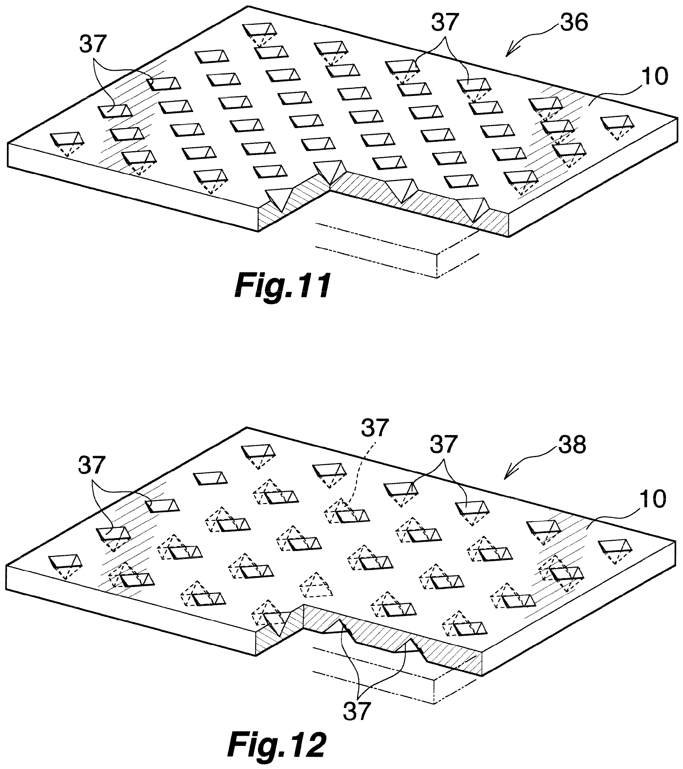

A stress relaxation member (36) shown in FIG. 11 (which does not form part of the claimed invention) is formed of the aluminum plate (10) in which a plurality of quadrangular-pyramid-shaped recesses (37) are formed in a staggered arrangement on one side, and the recesses (37) serve as stress-absorbing spaces.

A stress relaxation member (38) shown in FIG. 12 (which does not form part of the claimed invention) is formed of the aluminum plate (10) in which a plurality of the quadrangular-pyramid-shaped recesses (37) are formed in vertical and horizontal rows on opposite sides, and the recesses (37) serve as stress-absorbing spaces. The recesses (37) formed on one side of the aluminum plate (10) differ from the recesses (37) formed on the other side in position as viewed in plane.

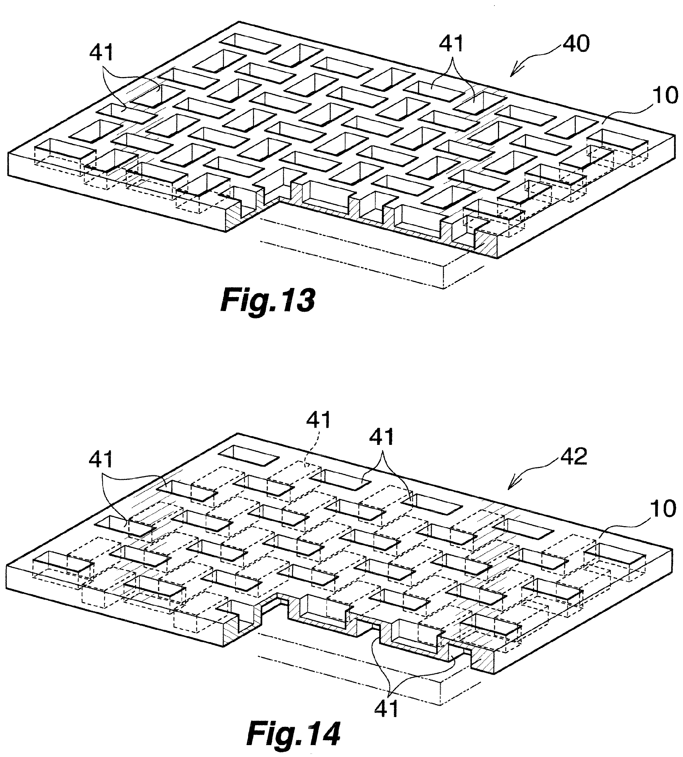

A stress relaxation member (40) shown in FIG. 13 (which does not form part of the claimed invention) is formed of the aluminum plate (10) in which a plurality of rectangular-parallelepiped-shaped recesses (41) are formed in vertical and horizontal rows on one side, and the recesses (41) serve as stress-absorbing spaces. Herein, the adjacent recesses (41) in each of the vertical rows are arranged such that their longitudinal directions are oriented 90 degrees different from each other. Similarly, the adjacent recesses (41) in each of the horizontal rows are arranged such that their longitudinal directions are oriented 90 degrees different from each other.

A stress relaxation member (42) shown in FIG. 14 (which does not form part of the claimed invention) is formed of the aluminum plate (10) in which a plurality of the rectangular-parallelepiped-shaped recesses (41) are formed in a staggered arrangement on opposite sides, and the recesses (41) serve as stress-absorbing spaces. The recesses (41) formed on one side of the aluminum plate (10) differ from the recesses (41) formed on the other side in position as viewed in plane. Also, the recesses (41) formed on a first side of the aluminum plate (10) are arranged such that their longitudinal directions are oriented in the same direction, and the recesses (41) formed on a second side of the aluminum plate (10) are arranged such that their longitudinal directions are oriented perpendicularly to those of the recesses (41) formed on the first side.

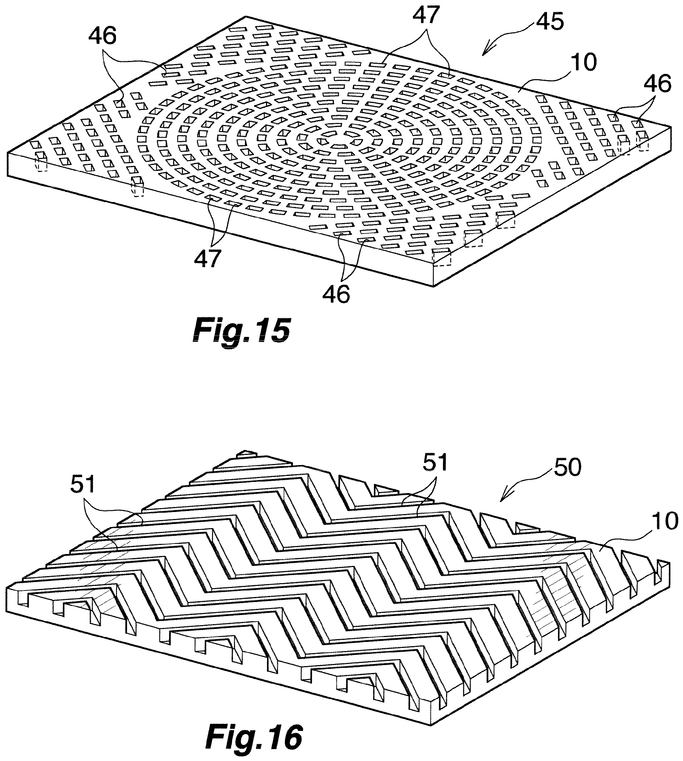

A stress relaxation member (45) shown in FIG. 15 (which does not form part of the claimed invention) is formed of the aluminum plate (10) in which a plurality of through holes (46) and (47) are formed, and the through holes (46) and (47) serve as stress-absorbing spaces. In four corner portions of the aluminum plate (10), a plurality of slit-like through holes (46) are formed on a plurality of diagonal lines which are in parallel with one another and intersect with two sides that define each of the corner portions, while the slit-like through holes (46) are spaced apart from one another along the diagonal lines. In a portion of the aluminum plate (10) other than the four corner portions, a plurality of arcuate through holes (47) are formed on a plurality of concentric circles while being circumferentially spaced apart from one another. Also, in this stress relaxation member (45), preferably, the percentage of the total area of all of the through holes (46) and (47) to the area of one side of the aluminum plate (10) is 3% to 50%.

A stress relaxation member (50) shown in FIG. 16 (which does not form part of the claimed invention) is formed of the aluminum plate (10) in which a plurality of groove-like recesses (51) are formed on one side, and the recesses (51) serve as stress-absorbing spaces. Some recesses (51) assume the form of connected letter Vs, and other recesses (51) assume the form of a letter V.

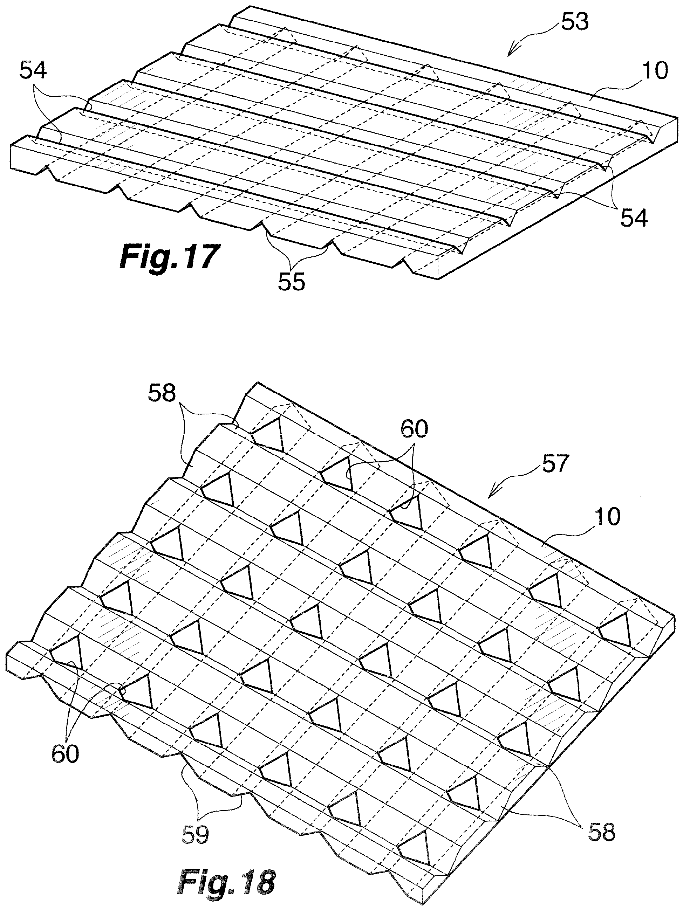

A stress relaxation member (53) shown in FIG. 17 (which does not form part of the claimed invention) is formed of the aluminum plate (10) in which a plurality of V-groove-like recesses (54) and (55) are formed on opposite sides, and the recesses (54) and (55) serve as stress-absorbing spaces. The recesses (54) formed on a first side of the aluminum plate (10) extend along the longitudinal direction of the aluminum plate (10) and are spaced apart from one another in the lateral direction of the aluminum plate (10). The recesses (55) formed on a second side of the aluminum plate (10) extend along the lateral direction of the aluminum plate (10) and are spaced apart from one another in the longitudinal direction of the aluminum plate (10). The total of the depth of the recesses (54) formed on the first side of the aluminum plate (10) and the depth of the recesses (55) formed on the second side of the aluminum plate (10) is less than the thickness of the aluminum plate (10).

A stress relaxation member (57) shown in FIG. 18 (which does not form part of the claimed invention) is formed of the aluminum plate (10) in which a plurality of V-groove-like recesses (58) and (59) are formed on opposite sides and in which a plurality of through holes (60) are formed, and the recesses (58) and (59) and the through holes (60) serve as stress-absorbing spaces. The recesses (58) formed on a first side of the aluminum plate (10) extend along the longitudinal direction of the aluminum plate (10) and are spaced apart from one another in the lateral direction of the aluminum plate (10). The recesses (59) formed on a second side of the aluminum plate (10) extend along the lateral direction of the aluminum plate (10) and are spaced apart from one another in the longitudinal direction of the aluminum plate (10). The total of the depth of the recesses (58) formed on the first side of the aluminum plate (10) and the depth of the recesses (59) formed on the second side of the aluminum plate (10) is greater than the thickness of the aluminum plate (10), whereby the through holes (60) are formed at intersections of the recesses (58) and (59).

The aluminum plate (10) used to form the stress relaxation members shown in FIGS. 4 to 18 is identical with that used to form the stress relaxation member (4) shown in FIG. 2. Each of the stress relaxation members shown in FIGS. 4 to 18 is brazed to the power module substrate (8) and to the heat sink (5) in a manner similar to that of the first and second embodiments.

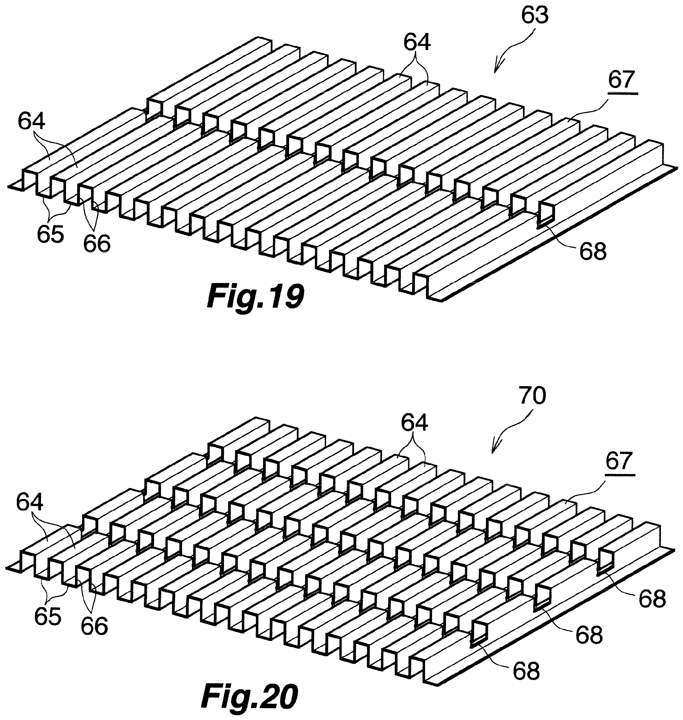

A stress relaxation member (63) shown in FIG. 19 (which does not form part of the claimed invention) is formed of a corrugate aluminum plate (67) which includes wave crest portions (64), wave trough portions (65), and connection portions (66) each connecting the wave crest portion (64) and the wave trough portion (65), and spaces present between the adjacent connection portions (66) serve as stress-absorbing spaces. A cutout portion (68) which extends at a laterally central portion of the corrugate aluminum plate (67) in a direction perpendicular to the longitudinal direction of the wave crest portions (64) and the wave trough portions (65) is formed at the wave crest portions (64), the wave trough portions (65), and the connection portions (66). Accordingly, the corrugate aluminum plate (67) is divided into two portions except for its opposite end portions.

A stress relaxation member (70) shown in FIG. 20 (which does not form part of the claimed invention) is configured as follows. A plurality of the cutout portions (68) are formed at the wave crest portions (64), the wave trough portions (65), and the connection portions (66) of the corrugate aluminum plate (67) similar to that of FIG. 19, in such a manner as to extend in a direction perpendicular to the longitudinal direction of the wave crest portions (64) and the wave trough portions (65) and to be juxtaposed to one another in the lateral direction of the corrugate aluminum plate (67). Accordingly, the corrugate aluminum plate (67) is divided into a plurality of portions except for its opposite end portions.

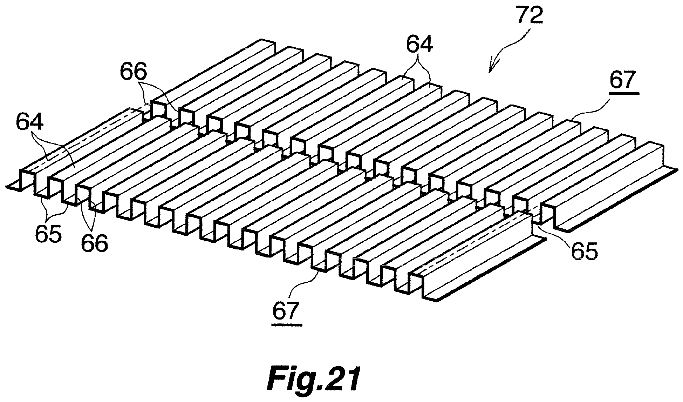

A stress relaxation member (72) shown in FIG. 21 (which does not form part of the claimed invention) is configured as follows. A plurality of; herein, two, corrugate aluminum plates (67) in which no cutout is formed are disposed in the longitudinal direction of the wave crest portions (64) and the wave trough portions (65) while being spaced apart from one another. No particular limitation is imposed on the number of the corrugate aluminum plates (67). The adjacent corrugate aluminum plates (67) are disposed such that the wave crest portions (64) and the wave trough portions (65) of one corrugate aluminum plate (67) are shifted from those of the other corrugate aluminum plate (67) in the lateral direction of the wave crest portions (64) and the wave trough portions (65).

In some cases, the stress relaxation member (72) shown in FIG. 21 may be configured as follows: the adjacent corrugate aluminum plates (67) are disposed such that the wave crest portions (64) and the wave trough portions (65) of one corrugate aluminum plate (67) coincide with those of the other corrugate aluminum plate (67) with respect to the lateral direction of the wave crest portions (64) and the wave trough portions (65).

In the stress relaxation members (63), (70), and (72) shown in FIGS. 19 to 21, respectively, the thickness of the corrugate aluminum plate (67) is preferably 0.05 mm to 1 mm. As in the case of the stress relaxation member (4) shown in FIG. 2, preferably, the corrugate aluminum plate (67) is formed of a pure aluminum having a purity of 99% or higher, desirably 99.5% or higher, which exhibits high thermal conductivity and high deformability induced by a drop in strength caused by brazing heat. As in the case of the above-described first and second embodiments, each of the stress relaxation members (63), (70), and (72) shown in FIGS. 19 to 21 is brazed to the power module substrate (8) and to the heat sink (5).

### INDUSTRIAL APPLICABILITY

The heat radiator of the present invention includes an insulating substrate whose first side serves as a heat-generating-element-mounting side and a heat sink fixed to a second side of the insulating substrate, and is preferably used for radiating, from the heat sink, heat generated from a heat-generating-element, such as a semiconductor device, mounted on the insulating substrate.

## Claims

1. A heat radiator (1) comprising an insulating substrate (3) whose first side serves as a heat-generating-element-mounting side, and a heat sink (5) fixed to a second side of the insulating substrate (3);
wherein the insulating substrate (3) is formed of a ceramic and a stress relaxation member (4), formed of an aluminum plate having a thickness of 0.3 mm to 3 mm and having a stress-absorbing space, intervenes between the insulating substrate (3) and the heat sink (5), and the stress relaxation member (4) is brazed to the insulating substrate (3) and to the heat sink (5), **characterized in that** cooling-fluid channels (11) are formed in the heat sink (5), the cooling-fluid channels (11) being parallel to the first and second sides of the insulating substrate (3), and the stress relaxation member (4) has a staggered arrangement of through holes (9) formed therein that serve as stress-absorbing space.

2. A heat radiator (1) according to claim 1, wherein the through holes (9) are formed in at least a portion of the aluminum plate (10) which corresponds to a perimetric portion of the insulating substrate (3).

3. A heat radiator (1) according to claim 1 or 2, wherein the through holes (9) are of a non-angular shape and have a circle-equivalent diameter of 1 mm to 4 mm.

4. A heat radiator (1) according to any one of claims 1 to 3, wherein a percentage of a total area of all of the through holes (9) to an area of one side of the aluminum plate (10) is 3% to 50%.

5. A heat radiator (1) according to any one of claims 1 to 4, wherein the aluminum plate (10, 67) is formed of pure aluminum having a purity of 99% or higher.

6. A power module comprising a heat radiator (1) according to any one of claims 1 to 5, and a semiconductor device (2) mounted on the insulating substrate (3) of the heat radiator.

## Patentansprüche

1. Wärmeradiator (1), umfassend ein isolierendes Substrat (3), dessen erste Seite als Wärmeerzeugungselement-Anbringungsseite dient, und einen Kühlkörper (5), der an einer zweiten Seite des isolierenden Substrats (3) befestigt ist,
wobei das isolierende Substrat (3) aus Keramik gebildet ist und ein Spannungsrelaxationselement (4), das aus einer Aluminiumplatte mit einer Dicke von 0,3 mm bis 3 mm gebildet ist und einen Spannungsaufnahmeraum aufweist, zwischen dem isolierenden Substrat (3) und dem Kühlkörper (5) angeordnet ist und das Spannungsrelaxationselement (4) an das isolierende Substrat (3) und an den Kühlkörper (5) gelötet ist, **dadurch gekennzeichnet, dass** in dem Kühlkörper (5) Kühlfluidkanäle (11) ausgebildet sind, wobei die Kühlfluidkanäle (11) zu der ersten und der zweiten Seite des isolierenden Substrats (3) parallel sind, und das Spannungsrelaxationselement (4) darin ausgebildet eine gestaffelte Anordnung von Durchgangslöchern (9) aufweist, die als Spannungsaufnahmeraum dienen.

2. Wärmeradiator (1) nach Anspruch 1, wobei die Durchgangslöcher (9) in mindestens einem Abschnitt der Aluminiumplatte (10) ausgebildet sind, der einem Umfangsabschnitt des isolierenden Substrats (3) entspricht.

3. Wärmeradiator (1) nach Anspruch 1 oder 2, wobei die Durchgangslöcher (9) eine nichtwinkelige Form aufweisen und einen kreisäquivalenten Durchmesser von 1 mm bis 4 mm aufweisen.

4. Wärmeradiator (1) nach einem beliebigen der Ansprüche 1 bis 3, wobei ein Prozentsatz einer Gesamtfläche aller Durchgangslöcher (9) zu einer Fläche einer Seite der Aluminiumplatte (10) 3 % bis 50 % beträgt.

5. Wärmeradiator (1) nach einem beliebigen der Ansprüche 1 bis 4, wobei die Aluminiumplatte (10, 67) aus reinem Aluminium mit einer Reinheit von 99 % oder höher gebildet ist.

6. Energiemodul, umfassend einen Wärmeradiator (1) nach einem beliebigen der Ansprüche 1 bis 5 und eine Halbleitervorrichtung (2), die an dem isolierenden Substrat (3) des Wärmeradiators angebracht ist.

## Revendications

1. Radiateur thermique (1) comprenant un substrat isolant (3) dont le premier côté sert de côté de montage d'élément générateur de chaleur, et un dissipateur thermique (5) fixé à un deuxième côté du substrat isolant (3) ;
dans lequel le substrat isolant (3) est formé d'une céramique et d'un élément de relaxation de contrainte (4), formé d'une tôle d'aluminium ayant une épaisseur de 0,3 mm à 3 mm et ayant un espace d'absorption de contrainte, intervient entre le substrat isolant (3) et le dissipateur thermique (5), et l'élément de relaxation de contrainte (4) est brasé au substrat isolant (3) et au dissipateur thermique (5), **caractérisé en ce que** des canaux de fluide caloporteur (11) sont formés dans le dissipateur thermique (5), les canaux de fluide caloporteur (11) étant parallèles aux premier et deuxième côtés du substrat isolant (3), et l'élément de relaxation de contrainte (4) a un agencement étagé de trous traversants (9) formés dans celui-ci qui servent d'espace d'absorption de contrainte.

2. Radiateur thermique (1) selon la revendication 1, dans lequel les trous traversants (9) sont formés dans au moins une partie de la tôle d'aluminium (10) qui correspond à une partie périmétrique du substrat isolant (3).

3. Radiateur thermique (1) selon la revendication 1 ou 2, dans lequel les trous traversants (9) ont une forme non angulaire et ont un diamètre équivalent au cercle de 1 mm à 4 mm.

4. Radiateur thermique (1) selon l'une quelconque des revendications 1 à 3, dans lequel le pourcentage de la superficie totale de tous les trous traversants (9) à la superficie d'un côté de la tôle d'aluminium (10) est de 3 % à 50 %.

5. Radiateur thermique (1) selon l'une quelconque des revendications 1 à 4, dans lequel la tôle d'aluminium (10, 67) est formée d'aluminium pur ayant une pureté de 99 % ou plus.

6. Bloc de puissance comprenant un radiateur thermique (1) de l'une quelconque des revendications 1 à 5, et un dispositif semiconducteur (2) monté sur le substrat isolant (3) du radiateur thermique.
